(19) Europäisches Patentamt
European Patent Office
Office européen des brevets

(11) **EP 4 099 498 B1**

(12) **FASCICULE DE BREVET EUROPEEN**

(45) Date de publication et mention de la délivrance du brevet:
**23.10.2024 Bulletin 2024/43**

(21) Numéro de dépôt: **22176211.5**

(22) Date de dépôt: **30.05.2022**

(51) Classification Internationale des Brevets (IPC):
*H01Q 1/22* *(2006.01)*    *H01Q 3/36* *(2006.01)*
*H01Q 3/46* *(2006.01)*    *H01Q 21/00* *(2006.01)*

(52) Classification Coopérative des Brevets (CPC):
**H01Q 1/2283; H01Q 3/36; H01Q 3/46; H01Q 21/0093**

(54) **EMPILEMENT POUR FABRIQUER UN CIRCUIT INTÉGRÉ DESTINÉ À ASSURER UNE FONCTION DE LENTILLE ÉLECTROMAGNÉTIQUE POUR UNE ANTENNE RECONFIGURABLE À RÉSEAU TRANSMETTEUR**

STAPEL ZUR HERSTELLUNG EINER INTEGRIERTEN SCHALTUNG ZUR BEREITSTELLUNG EINER ELEKTROMAGNETISCHEN LINSENFUNKTION FÜR EINE REKONFIGURIERBARE ANTENNE MIT ÜBERTRAGUNGSNETZ

STACK FOR MANUFACTURING AN INTEGRATED CIRCUIT INTENDED FOR PROVIDING AN ELECTROMAGNETIC LENS FUNCTION FOR A RECONFIGURABLE ANTENNA WITH TRANSMITTER NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.06.2021 FR 2105741**

(43) Date de publication de la demande:
**07.12.2022 Bulletin 2022/49**

(73) Titulaire: **Commissariat à l'énergie atomique et aux énergies alternatives**
**75015 Paris (FR)**

(72) Inventeurs:
• **PARES, Gabriel**
**38054 Grenoble Cedex 09 (FR)**
• **CLEMENTE, Antonio**
**38054 Grenoble Cedex 09 (FR)**
• **REIG, Bruno**
**38054 Grenoble Cedex 09 (FR)**

(74) Mandataire: **INNOV-GROUP**
**209 Avenue Berthelot**
**69007 Lyon (FR)**

(56) Documents cités:
**US-A1- 2018 301 807**

EP 4 099 498 B1

## Description

## Domaine technique

L'invention se rapporte au domaine technique des antennes à réseau transmetteur (« *Transmitarray antenna*» en langue anglaise). Une antenne à réseau transmetteur comporte :

- un réseau transmetteur (appelé également lentille électromagnétique ou lentille discrète), comprenant un ensemble de cellules élémentaires pouvant être disposé sous forme matricielle (la matrice peut être régulière ou éparse ; la matrice régulière peut, par exemple, comporter un maillage carré ou triangulaire) ;
- au moins une source rayonnante (dite source primaire), agencée pour illuminer le réseau transmetteur.

Chaque cellule élémentaire du réseau transmetteur est susceptible d'introduire un déphasage à l'onde incidente émise par la ou les sources primaires, afin de compenser chaque différence de trajet du rayonnement émis entre la ou les sources primaires et le réseau transmetteur. Les cellules élémentaires permettent de générer la loi de phase dans l'ouverture de rayonnement afin de former le rayonnement désiré pour l'antenne.

Plus précisément, chaque cellule élémentaire du réseau transmetteur peut comporter au moins :

- une première antenne planaire (dite de réception), agencée pour recevoir l'onde incidente émise par la ou les sources primaires ;
- une deuxième antenne planaire (dite de transmission), agencée pour transmettre avec un déphasage l'onde incidente reçue par la première antenne planaire.

Par « antenne planaire », on entend une surface plane électriquement conductrice (classiquement métallique) pouvant émettre/recevoir un rayonnement électromagnétique. Un exemple d'antenne planaire est la pastille micro-ruban (« *patch* » en langue anglaise).

D'autres architectures de cellules élémentaires peuvent également être utilisées, telles que des structures multicouches basées sur le concept des surfaces sélectives en fréquence, ou sur le concept des cavités Fabry-Pérot. Les éléments rayonnants de type dipôles, fentes etc. peuvent être aussi utilisés au niveau de la cellule élémentaire.

Il est à noter qu'une cellule élémentaire d'un réseau transmetteur peut fonctionner en réception ou en transmission, c'est-à-dire que la première antenne planaire de la cellule élémentaire peut également être une antenne de transmission, tandis que la deuxième antenne planaire de la cellule élémentaire peut également être une antenne de réception.

L'invention trouve notamment son application dans l'obtention d'une antenne reconfigurable. Par « reconfigurable », on entend qu'au moins une caractéristique de l'antenne peut être modifiée au cours de sa durée de vie, après sa fabrication. La ou les caractéristiques généralement modifiables sont la réponse fréquentielle (en amplitude et en phase), le diagramme de rayonnement (appelé également faisceau), et la polarisation. La reconfiguration de la réponse fréquentielle couvre différentes fonctionnalités telles que la commutation de fréquences, l'accord en fréquence, la variation de bande passante, le déphasage, le filtrage fréquentiel etc. La reconfiguration du diagramme de rayonnement couvre différentes fonctionnalités telles que le balayage angulaire de la direction de pointage du faisceau (appelé également dépointage), l'ouverture du faisceau typiquement défini à mi-puissance (c'est-à-dire la concentration du rayonnement suivant une direction particulière), le filtrage spatial (lié à l'ouverture et à la formation du faisceau), la formation d'un faisceau ou de multifaisceaux (e.g. plusieurs faisceaux étroits remplaçant un faisceau large) etc. Une antenne reconfigurable à réseau transmetteur est particulièrement avantageuse à partir de la bande C (4-8 GHz) jusqu'à la bande W (75-110 GHz), voire la bande D (110-170 GHz) ou jusqu'à la bande 300 GHz, pour les applications suivantes :

- radars automobiles d'assistance et d'aide à la conduite, dans une perspective de sécurité active,
- systèmes d'imagerie et de surveillance à très haute résolution,
- systèmes de communication à très haut débit, fonctionnant notamment dans les bandes millimétriques (communications inter-bâtiments ou intra-bâtiment en environnement domotique ou immotique, et particulièrement adaptées au suivi d'utilisateurs),
- liaisons de télémesure sol-satellite en orbite basse LEO (pour « *Low Earth Orbit*» en langue anglaise) en bande Ka, télécommunications par satellite avec source primaire reconfigurable (SOTM™ pour « *Satcom-on-the-Move* » en langue anglaise, internet, télévision etc.),
- systèmes de liaison point-à-point et point-à-multipoint (réseaux métropolitains, systèmes « *Frontbhaul*» et « *Backbaul*» pour les réseaux cellulaires, accès radio pour les réseaux mobiles de cinquième génération etc.).

## État de l'art

Les bandes de fréquence millimétriques sont très intéressantes pour les systèmes de communication radio, grâce à de larges bandes spectrales disponibles autorisant des débits de transmission élevés. Par exemple, la bande autour de 60 GHz (57-66 GHz) est une bande libre, pouvant être exploitée sans licence dans le monde entier, et qui suscite donc un fort intérêt. Les communications sans fil autour de 60 GHz sont néanmoins limitées :

- d'une part, par la résonance des molécules de dioxygène présentes dans l'air, qui absorbent une grande partie de l'énergie émise par le système de communication radio,
- d'autre part, par les pertes liées à la propagation des ondes électromagnétiques dans l'espace libre (notées FSPL pour « *Free-Space Path Loss* » en langue anglaise) qui suivent une loi quadratique par rapport à la fréquence opérationnelle :

$$FSPL = \left(\frac{4\pi df}{c}\right)^2$$

où « d » est la distance entre deux antennes, « f » est la fréquence opérationnelle, et « c » est la célérité des ondes électromagnétiques (i.e. la vitesse de propagation dans le vide).

Il en résulte que le système de communication radio nécessite un fort gain. Cette problématique est commune aux fréquences millimétriques et sub-THz à partir de 30 GHz.

Il est connu de l'état de la technique, notamment de la thèse de doctorat de J. A. Zevallos Luna, « Intégration d'antennes pour objets communicants aux fréquences millimétriques », octobre 2014 (ci-après D1), d'associer un module émetteur-récepteur (« *Transceiver*» en langue anglaise) à un réseau transmetteur passif (cf. figure 6.1 de D1, et §5.4). Le réseau transmetteur est imprimé sur un substrat diélectrique (cf. figure 6.2 a) de D1). Le circuit intégré de l'émetteur-récepteur est formé sur une carte de circuit imprimé. Le réseau transmetteur est formé sur la carte de circuit imprimé, en regard de l'émetteur-récepteur, par l'intermédiaire de piliers diélectriques soutenant le substrat diélectrique.

Une telle solution de l'état de la technique n'est pas entièrement satisfaisante dans la mesure où les piliers diélectriques nuisent à la compacité du système de communication radio. En outre, l'antenne obtenue n'est pas reconfigurable en raison du réseau transmetteur passif.

US 2018/301807 A1 divulgue une empilement comprenant une cellule élémentaire. Cette cellule élémentaire comporte: une antenne de réception planaire, une antenne de transmission planaire, et comprenant des première et deuxième surfaces de rayonnement disjointes; un premier circuit de déphasage, comprenant des premier et second commutateurs présentant respectivement un état passant et un état bloqué, en alternance, entre les première et deuxième surfaces de rayonnement de l'antenne de transmission; l'antenne de réception comprend des première et deuxième surfaces de captation disjointes; et la cellule élémentaire comporte un deuxième circuit de déphasage comprenant des premier et second commutateurs présentant respectivement un état passant et un état bloqué, en alternance, entre les première et deuxième surfaces de captation de l'antenne de réception.

## Exposé de l'invention

L'invention vise à remédier en tout ou partie aux inconvénients précités. A cet effet, l'invention a pour objet un empilement pour fabriquer un circuit intégré destiné à assurer une fonction de lentille électromagnétique pour une antenne reconfigurable à réseau transmetteur, l'empilement comportant successivement :

- un substrat, comprenant un ensemble de premiers composants actifs configurés pour introduire un déphasage, et présentant des première et seconde surfaces opposées ; les premiers composants actifs étant intégrés de manière monolithique au substrat ;
- une couche métallique, formant un plan de masse à la première surface du substrat ;
- une couche d'un polymère durci, formée sur la couche métallique ;

l'empilement comportant :

- une première structure d'interconnexions, formée à la seconde surface du substrat, et électriquement connectée aux premiers composants actifs ; la première structure d'interconnexions comprenant des premières lignes de polarisation agencées pour polariser les premiers composants actifs ;
- un ensemble de premières antennes planaires, formé sur la première structure d'interconnexions de manière à être électriquement connecté aux premiers composants actifs ;
- un ensemble de deuxièmes antennes planaires, formé sur la couche d'un polymère durci ; les ensembles des premières et deuxièmes antennes planaires étant alignés suivant la normale aux première et seconde surfaces du substrat ;
- des trous d'interconnexions, électriquement isolés de la couche métallique, et agencés pour connecter électriquement des couples d'antennes planaires ; chaque couple d'antennes planaires électriquement connecté comprenant des première et deuxième antennes planaires alignées suivant la normale aux première et seconde surfaces du substrat.

## Définitions

- Par « lentille électromagnétique », on entend un réseau transmetteur, appelé également lentille discrète.
- Par « substrat», on entend un support physique autoporté, réalisé dans un matériau de base permettant l'intégration monolithique des premiers composants actifs. Le substrat peut être une « tranche » (également dénommée « plaquette », « wafer » en langue anglaise) qui se présente généralement sous la forme d'un disque issu d'une découpe dans un lingot d'un matériau cristallin.

- Par « composants actifs », on entend des composants permettant d'agir, à l'aide d'un signal de commande (e.g. électronique ou optique), sur les caractéristiques de propagation d'une onde électromagnétique. Les composants actifs peuvent être intégrés de manière monolithique au substrat dans une ligne de fabrication de dispositifs semi-conducteurs FEOL (« Front-End-Of-Line » en langue anglaise, on parle également d'unité de fabrication initiale), en utilisant par exemple des techniques de photolithographie, gravure, diffusion et implantation de dopants, dépôts métalliques, passivation etc. Les composants actifs sont de préférence des commutateurs.
- Par « déphasage », on entend une modification de la phase d'une onde électromagnétique incidente, introduit par le ou les composants actifs, par exemple en provoquant un décalage temporel (retard temporel) de l'onde électromagnétique incidente.
- Par « plan de masse », on entend une zone métallique formant un plan de masse électrique de manière à définir un potentiel de référence.
- Par « polymère durci », on entend le produit obtenu à l'issue d'un moulage d'un polymère, ou autrement dit le polymère moulé. Le polymère peut être un thermoplastique ou un thermodurcissable, ce dernier étant à privilégier.
- Par « structure d'interconnexions », on entend un empilement de niveaux d'interconnexions comprenant des pistes métalliques noyées dans un matériau diélectrique. Une structure d'interconnexions peut être formée sur le substrat dans une ligne de fabrication de niveaux d'interconnexions électriques BEOL (« Back-End-Of-Line » en langue anglaise, on parle également d'unité de fabrication finale).
- Par « antenne planaire », on entend une surface plane électriquement conductrice (classiquement métallique) pouvant émettre/recevoir un rayonnement électromagnétique. Un exemple d'antenne planaire est la pastille micro-ruban (« patch » en langue anglaise).
- L'expression « un ensemble de deuxièmes antennes planaires, formé sur la couche d'un polymère durci » ne signifie pas nécessairement que les deuxièmes antennes planaires sont formées directement sur la couche d'un polymère durci. Cette expression n'exclut pas la présence d'une entité interposée entre la couche d'un polymère durci et les deuxièmes antennes planaires, par exemple une structure d'interconnexions.
- Par « trou d'interconnexion » (« via» en langue anglaise), on entend un trou métallisé permettant d'établir une liaison électrique entre différents niveaux d'interconnexions.

Ainsi, un tel empilement selon l'invention permet une intégration monolithique des cellules élémentaires du réseau transmetteur avec les premiers composants actifs permettant de contrôler et modifier le déphasage introduit dans la cellule correspondante, et ce de manière à pouvoir obtenir une antenne reconfigurable.

En outre, une telle intégration monolithique permet l'obtention future d'un circuit intégré avec des dimensions suffisamment faibles pour être compatibles avec des fréquences de fonctionnement de l'antenne reconfigurable supérieures à 30 GHz. En effet, afin d'obtenir des performances satisfaisantes, la dimension (et donc la périodicité) caractéristique des cellules élémentaires doit être inférieure ou égale à la demi-longueur d'onde des ondes électromagnétiques émises par la ou les sources primaires. Par exemple, lorsque la fréquence de fonctionnement est de 30 GHz, la dimension caractéristique des cellules élémentaires doit être inférieure ou égale à 0,5 cm.

L'empilement selon l'invention peut comporter une ou plusieurs des caractéristiques suivantes.

Selon une caractéristique de l'invention, l'empilement comporte des démultiplexeurs encapsulés dans la couche d'un polymère durci, désaxés par rapport aux couples d'antennes planaires électriquement connectés, les démultiplexeurs étant électriquement connectés aux premières lignes de polarisation pour transmettre un signal de commande.

Ainsi, un avantage procuré est d'obtenir une intégration monolithique des démultiplexeurs avec les cellules élémentaires du réseau transmetteur et les premiers composants actifs. La couche d'un polymère durci assure le rôle d'un boîtier de circuit intégré. Les démultiplexeurs peuvent être intégrés de manière monolithique avec la couche d'un polymère durci grâce à une technique de mise en boîtier à l'échelle du substrat avec épanouissement externe des interconnexions (« Fan-out wafer-level packaging» en langue anglaise). L'épanouissement externe des interconnexions (« fan-out » en langue anglaise, on parle également de déploiement externe des interconnexions) signifie qu'il est possible d'avoir un boîtier avec des interconnexions additionnelles s'étendant au-delà des plots de la puce encapsulée (e.g. une puce de démultiplexeur) dans le boîtier. Autrement dit, les interconnexions du boîtier peuvent s'étendre au-delà de la surface de la puce encapsulée dans le boîtier (plus précisément au-delà du projeté orthogonal de la surface de la puce dans le plan des interconnexions du boîtier). A contrario, on parle d'épanouissement interne des interconnexions (« fan-in » en langue anglaise, on parle également de déploiement interne des interconnexions) lorsque les interconnexions du boîtier (e.g. billes de brasage) sont circonscrites par la surface de la puce encapsulée dans le boîtier. Autrement dit, les interconnexions du boîtier s'étendent dans les limites de la surface de la puce (plus précisément dans les limites du projeté orthogonal de la surface de la puce dans le plan des interconnexions du boîtier).

Les démultiplexeurs sont désaxés par rapport aux couples d'antennes planaires électriquement connectés de manière à ne pas gêner la propagation d'ondes incidentes.

Selon une caractéristique de l'invention, l'ensemble de premiers composants actifs comporte des couples de commutateurs, chaque couple de commutateurs étant associé à une première antenne planaire ; les premiers composants actifs étant de préférence choisis parmi une diode, un transistor à effet de champ, un transistor bipolaire, un microsystème électromécanique.

## Définition

Par « commutateurs », on entend des éléments permettant d'autoriser ou d'interdire la circulation d'un courant électrique, par exemple entre deux surfaces de rayonnement disjointes d'une antenne planaire.

Ainsi, un avantage procuré est de pouvoir introduire un déphasage en modifiant la longueur électrique effective de la première antenne planaire.

Selon une caractéristique de l'invention, l'empilement comporte une deuxième structure d'interconnexions, intercalée entre la couche d'un polymère durci et l'ensemble de deuxièmes antennes planaires ; empilement dans lequel :

- la couche d'un polymère durci présente une surface, orientée vers la deuxième structure d'interconnexions, et munie d'un ensemble de deuxièmes composants actifs configurés pour introduire un déphasage ;
- la deuxième structure d'interconnexions est électriquement connectée aux deuxièmes composants actifs, et comprend des deuxièmes lignes de polarisation agencées pour polariser les deuxièmes composants actifs ;
- l'ensemble de deuxièmes antennes planaires est formé sur la deuxième structure d'interconnexions de manière à être électriquement connecté aux deuxièmes composants actifs.

Ainsi, un avantage procuré est d'augmenter le nombre d'états de phase ou de retards.

Selon une caractéristique de l'invention, l'ensemble de deuxièmes composants actifs comporte des couples de commutateurs, chaque couple de commutateurs étant associé à une deuxième antenne planaire ; les deuxièmes composants actifs étant de préférence choisis parmi une diode, un transistor à effet de champ, un transistor bipolaire, un microsystème électromécanique.

Ainsi, un avantage procuré est de pouvoir introduire un déphasage en modifiant la longueur électrique effective de la deuxième antenne planaire.

Selon une caractéristique de l'invention, les démultiplexeurs sont électriquement connectés aux deuxièmes lignes de polarisation.

Ainsi, un avantage procuré est de pouvoir commander les deuxièmes composants actifs.

Selon une caractéristique de l'invention :

- chaque deuxième antenne planaire comporte des première et seconde surfaces de rayonnement disjointes ;
- les premières surfaces de rayonnement des deuxièmes antennes planaires sont électriquement connectées aux trous d'interconnexions et aux deuxièmes composants actifs ;
- les secondes surfaces de rayonnement des deuxièmes antennes planaires sont électriquement connectées aux deuxièmes composants actifs.

## Définition

Par « disjointes », on entend que les première et seconde surfaces de rayonnement sont séparées entre elles par une zone de séparation de manière à être électriquement isolées.

Selon une caractéristique de l'invention :

- chaque première antenne planaire comporte des première et seconde surfaces de rayonnement disjointes ;
- les premières surfaces de rayonnement des premières antennes planaires sont électriquement connectées aux trous d'interconnexions et aux premiers composants actifs ;
- les secondes surfaces de rayonnement des premières antennes planaires sont électriquement connectées aux premiers composants actifs.

Selon une caractéristique de l'invention, le substrat est choisi parmi :

- un substrat réalisé à base d'un matériau semi-conducteur ou constitué d'un matériau semi-conducteur ;
- un substrat réalisé dans un matériau diélectrique.

## Définitions

- Par « à base de », on entend que le matériau semi-conducteur est le matériau principal et majoritaire composant le substrat.
- Par « semi-conducteur », on entend que le matériau présente une conductivité électrique à 300 K comprise entre 10 * S/cm et $10^3$ S/cm.
- Par « constitué », on entend que le matériau semi-conducteur est le seul et unique matériau composant le substrat.

- Par « diélectrique », on entend que le matériau présente une conductivité électrique à 300 K inférieure à $10^{-8}$ S/cm.

Selon une caractéristique de l'invention, le polymère durci est un polymère thermodurcissable, de préférence un polyépoxyde.

Ainsi, un avantage procuré est de pouvoir aisément former la couche du polymère durci par moulage.

Selon une caractéristique de l'invention, la couche d'un polymère durci présente une épaisseur comprise entre 300 $\mu$m et 800 $\mu$m.

## Définition

Par « épaisseur », on entend la dimension suivant la normale aux première et seconde surfaces du substrat.

Ainsi, un avantage procuré est de pouvoir encapsuler des puces électroniques (e.g. des démultiplexeurs) au sein de la couche d'un polymère durci.

L'invention a également pour objet un circuit intégré, fabriqué par une découpe d'un empilement selon l'invention suivant la normale aux première et seconde surfaces du substrat, de manière à obtenir une pluralité de cellules élémentaires destinée à assurer une fonction de lentille électromagnétique pour une antenne reconfigurable à réseau transmetteur, chaque cellule élémentaire comportant des première et deuxième antennes planaires alignées suivant la normale aux première et seconde surfaces du substrat.

Autrement dit, l'invention a également pour objet un circuit intégré destiné à assurer une fonction de lentille électromagnétique pour une antenne reconfigurable à réseau transmetteur, fabriqué à partir d'un empilement selon l'invention, le circuit intégré comportant successivement :

- une partie du substrat, comprenant des premiers composants actifs configurés pour introduire un déphasage, et présentant des première et seconde surfaces opposées ; les premiers composants actifs étant intégrés de manière monolithique à la partie du substrat ;
- une partie de la couche métallique, formant un plan de masse à la première surface de la partie du substrat ;
- une partie de la couche d'un polymère durci, formée sur la partie de la couche métallique ;

le circuit intégré comportant :

- une partie de la première structure d'interconnexions, formée à la seconde surface de la partie du substrat, et électriquement connectée aux premiers composants actifs ; la partie de la première structure d'interconnexions comprenant des premières lignes de polarisation agencées pour polariser les premiers composants actifs ;
- des premières antennes planaires, formées sur la partie de la première structure d'interconnexions de manière à être électriquement connecté aux premiers composants actifs ;
- des deuxièmes antennes planaires, formées sur la partie de la couche d'un polymère durci ; les premières et deuxièmes antennes planaires étant alignées suivant la normale aux première et seconde surfaces de la partie du substrat ;
- une partie des trous d'interconnexions, électriquement isolés de la partie de la couche métallique, et agencés pour connecter électriquement des couples d'antennes planaires ; chaque couple d'antennes planaires électriquement connecté comprenant des première et deuxième antennes planaires alignées suivant la normale aux première et seconde surfaces de la partie du substrat.

L'invention a également pour objet une antenne reconfigurable à réseau transmetteur, comportant :

- une carte de circuit imprimé, présentant des première et seconde surfaces opposées ;
- au moins un circuit intégré selon l'invention, formé à la première surface de la carte de circuit imprimé ;
- au moins un émetteur-récepteur, agencé pour émettre et recevoir une onde électromagnétique se propageant au sein de la carte de circuit imprimé ;
- au moins une électronique de commande, configurée pour commander l'émetteur-récepteur et les premiers composants actifs du circuit intégré, et formée à la seconde surface de la carte de circuit imprimé.

Ainsi, un avantage procuré est d'obtenir une antenne reconfigurable à réseau transmetteur très compacte en utilisant les deux faces opposées d'une carte de circuit imprimé pour intégrer la lentille électromagnétique et l'électronique de commande.

Selon une caractéristique de l'invention, l'électronique de commande est configurée pour commander les deuxièmes composants actifs du circuit intégré.

Selon une caractéristique de l'invention, l'antenne comporte des antennes planaires additionnelles, formées à la première surface de la carte de circuit imprimé, et alignées avec les cellules élémentaires du circuit intégré suivant la normale aux première et seconde surfaces du substrat.

Ainsi, un avantage procuré est d'obtenir un réseau transmetteur capable de gérer des faisceaux indépendants, par exemple pour des applications multi-utilisateurs.

## Brève description des dessins

D'autres caractéristiques et avantages apparaîtront dans l'exposé détaillé de différents modes de réalisation de l'invention, l'exposé étant assorti d'exemples et de références aux dessins joints.

Figure 1 est une vue schématique partielle en coupe illustrant un premier mode de réalisation d'un empilement selon l'invention. Les traits pointillés indiquent une cellule élémentaire.

Figure 2 est une vue schématique partielle en coupe illustrant un deuxième mode de réalisation d'un empilement selon l'invention. Les traits pointillés indiquent une cellule élémentaire.

Figure 3 est une vue schématique partielle en coupe illustrant un troisième mode de réalisation d'un empilement selon l'invention. Les traits pointillés indiquent une cellule élémentaire.

Figure 4 est une vue schématique partielle en coupe illustrant un quatrième mode de réalisation d'un empilement selon l'invention. Les traits pointillés indiquent une cellule élémentaire.

Figure 5 est une vue schématique de dessus d'un empilement selon l'invention, illustrant la formation de motifs à la surface de l'empilement, par exemple par photolithographie à l'aide d'un masque (réticule). L'encart de la figure 5 est vue de dessus à l'échelle agrandie d'un motif, formé à la surface de l'empilement, et comportant plusieurs cellules élémentaires.

Figure 6 est une vue schématique en coupe d'une antenne reconfigurable selon l'invention.

Figure 7 est une vue schématique de dessus d'une antenne reconfigurable selon l'invention.

Figure 8 est une vue schématique en coupe d'une antenne reconfigurable selon l'invention, illustrant un mode de réalisation où des antennes planaires additionnelles sont formées à la surface de la carte de circuit imprimé.

Figure 9 est une vue schématique en coupe d'une antenne reconfigurable selon l'invention, illustrant un mode de réalisation où la carte de circuit imprimé est munie d'une pluralité de modules émetteur-récepteur. Les traits pointillés indiquent une zone de formation d'un faisceau sur une bande passante.

Figure 10 est une vue schématique en coupe d'une antenne reconfigurable selon l'invention, illustrant un mode de réalisation où la carte de circuit imprimé est munie d'un module émetteur-récepteur numérique. Les traits pointillés indiquent une zone de formation d'un faisceau sur une bande passante.

Il est à noter que les dessins décrits ci-avant sont schématiques, et ne sont pas à l'échelle par souci de lisibilité et pour en simplifier leur compréhension.

## Exposé détaillé des modes de réalisation

Les éléments identiques ou assurant la même fonction porteront les mêmes références pour les différents modes de réalisation, par souci de simplification.

*Empilement*

Un objet de l'invention est un empilement 1 pour fabriquer un circuit intégré IC destiné à assurer une fonction de lentille électromagnétique pour une antenne 2 reconfigurable à réseau transmetteur, l'empilement 1 comportant successivement :

- un substrat 3, comprenant un ensemble de premiers composants actifs C1 configurés pour introduire un déphasage, et présentant des première et seconde surfaces 30, 31 opposées ; les premiers composants actifs C1 étant intégrés de manière monolithique au substrat 3 ;
- une couche métallique 4, formant un plan de masse à la première surface 30 du substrat 3 ;
- une couche d'un polymère 5 durci, formée sur la couche métallique 4 ;

l'empilement 1 comportant :

- une première structure 6 d'interconnexions, formée à la seconde surface 31 du substrat 3, et électriquement connectée aux premiers composants actifs C1 ; la première structure 6 d'interconnexions comprenant des premières lignes de polarisation 60 agencées pour polariser les premiers composants actifs C1 ;
- un ensemble de premières antennes planaires A1, formé sur la première structure 6 d'interconnexions de manière à être électriquement connecté aux premiers composants actifs C1 ;
- un ensemble de deuxièmes antennes planaires A2, formé sur la couche d'un polymère 5 durci ; les ensembles des premières et deuxièmes antennes planaires A1, A2 étant alignés suivant la normale aux première et seconde surfaces 30, 31 du substrat 3 ;
- des trous d'interconnexions V, électriquement isolés de la couche métallique 4, et agencés pour connecter électriquement des couples d'antennes planaires ; chaque couple d'antennes planaires électriquement connecté comprenant des première et deuxième antennes planaires A1, A2 alignées suivant la normale aux première et seconde surfaces 30, 31 du substrat 3.

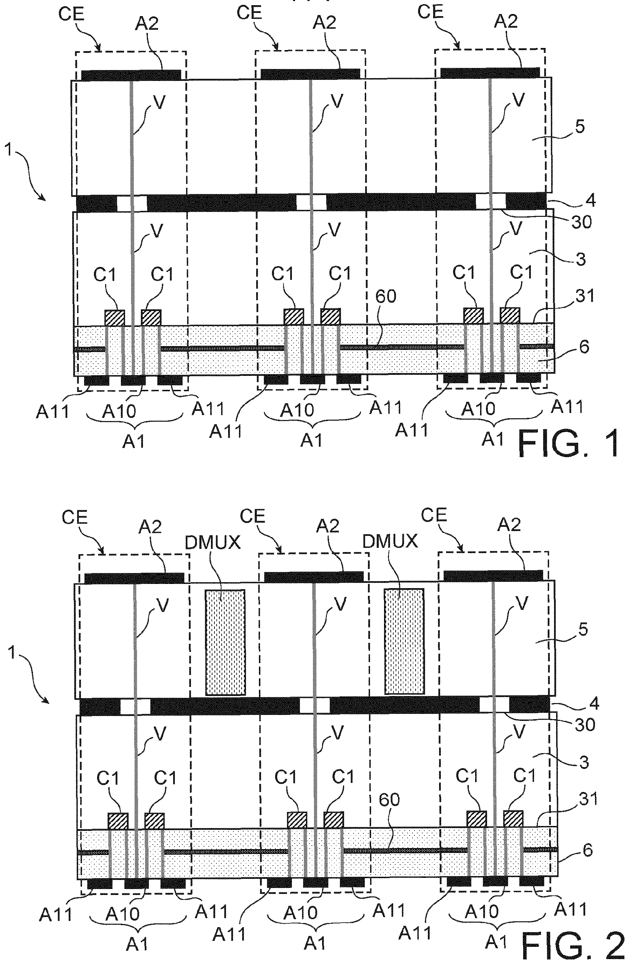

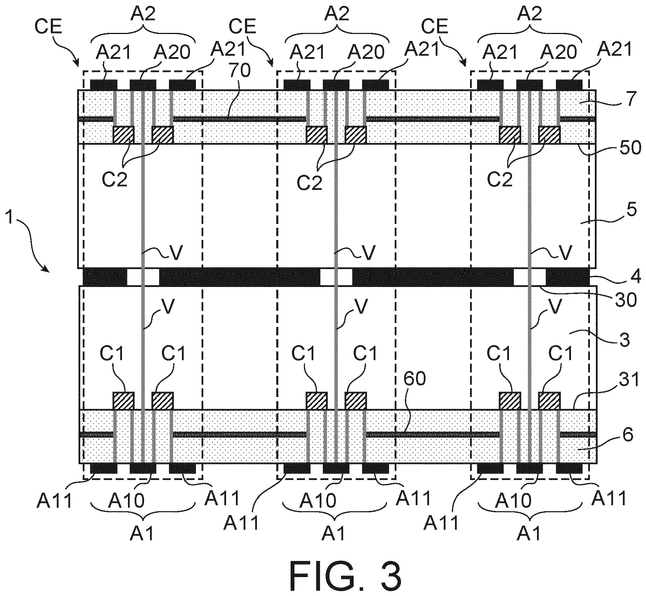

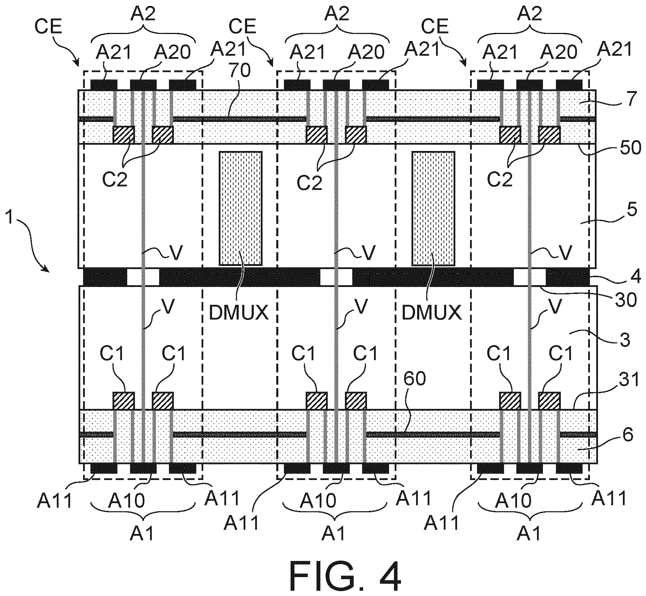

Différents modes de réalisation de l'empilement 1 sont illustrés aux figures 1 à 4.

## Substrat

Le substrat 3 est avantageusement choisi parmi :

- un substrat 3 réalisé à base d'un matériau semi-conducteur ou constitué d'un matériau semi-conducteur ;
- un substrat 3 réalisé dans un matériau diélectrique.

Le matériau semi-conducteur est de préférence sélectionné parmi le silicium et le germanium. Le substrat 3 peut être de type Semi-conducteur sur Isolant SeOI (« *Semiconductor On Insulator*» en langue anglaise), de préférence de type Silicium sur Isolant SOI *(« Silicon on Insulator*» en langue anglaise).

Le matériau diélectrique est de préférence sélectionné parmi un verre et le quartz.

Le substrat 3 peut présenter une épaisseur comprise entre 300 $\mu$m et 700 $\mu$m.

## Ensemble de premiers composants actifs

Les premiers composants actifs C1 sont avantageusement intégrés de manière monolithique au substrat 3 dans une ligne de fabrication de dispositifs semi-conducteurs FEOL (« *Front-End-Of-Line*» en langue anglaise), en utilisant par exemple des techniques de photolithographie, gravure, diffusion et implantation de dopants, dépôts métalliques, passivation connues de l'homme du métier. Dans le cas où le substrat 3 est réalisé dans un matériau diélectrique, les premiers composants actifs C1 peuvent être intégrés de manière monolithique au substrat 3 par des techniques de dépôt de couches minces.

Chaque première antenne planaire A1 comporte avantageusement des première et seconde surfaces de rayonnement A10, A11 disjointes, au sens où elles sont séparées entre elles par une zone de séparation de manière à être électriquement isolées entre elles. L'ensemble de premiers composants actifs C1 comporte avantageusement des couples de commutateurs, chaque couple de commutateurs étant associé à une première antenne planaire A1. Chaque couple de commutateurs appartient à un circuit de déphasage, et comprend des premier et second commutateurs présentant respectivement un état passant et un état bloqué en alternance, les états passant ou bloqué correspondant à une circulation d'un courant, respectivement autorisée ou bloquée, entre les première et seconde surfaces de rayonnement A10, A11 disjointes de chaque première antenne planaire A1. Par « en alternance », on entend que le premier commutateur alterne entre l'état passant et l'état bloqué, tandis que, simultanément, le second commutateur alterne entre l'état bloqué et l'état passant. En d'autres termes, à tout instant, les premier et second commutateurs appartenant au même circuit de déphasage présentent deux états opposés, soit passant/bloqué, soit bloqué/passant. Les états passant/passant ou bloqué/bloqué ne sont pas autorisés.

Les premiers composants actifs C1 sont de préférence choisis parmi une diode, un transistor à effet de champ, un transistor bipolaire, un microsystème électromécanique. Le transistor à effet de champ est de préférence un transistor de type MOS (« *Metal Oxide Semiconductor*» en langue anglaise). La diode peut être une diode de type p-i-n, une diode électro-optique, ou encore une diode de type varicap (« *varactor*» en langue anglaise). Les diodes de type p-i-n peuvent être réalisées en AlGaAs.

## Première structure d'interconnexions

La première structure 6 d'interconnexions est avantageusement formée à la seconde surface 31 du substrat 3 dans une ligne de fabrication de niveaux d'interconnexions électriques BEOL (« *Back-End-Of-Line*» en langue anglaise).

Les premières lignes de polarisation 30 sont des pistes métalliques, de préférence réalisées en cuivre.

## Ensemble de premières antennes planaires

L'ensemble de premières antennes planaires A1 est formé sur la première structure 6 d'interconnexions de sorte que les premières antennes planaires A1 sont électriquement isolées entre elles afin de ne pas être mises en court-circuit.

Chaque première antenne planaire A1 comporte avantageusement des première et seconde surfaces de rayonnement A10, A11 disjointes, au sens où elles sont séparées entre elles par une zone de séparation de manière à être électriquement isolées entre elles. A cet effet, une fente est avantageusement formée dans chaque première antenne planaire A1 pour isoler électriquement les première et seconde surfaces de rayonnement A10, A11 disjointes. La fente définit la zone de séparation. La fente est préférentiellement annulaire, à section rectangulaire. Bien entendu, d'autres formes sont envisageables pour la fente, telles qu'une forme elliptique ou circulaire. Selon une variante d'exécution, l'isolation électrique des première et seconde surfaces de rayonnement A10, A11 de la première antenne planaire A1 peut être assurée par un matériau diélectrique.

Les premières surfaces de rayonnement A10 des premières antennes planaires A1 sont électriquement connectées aux trous d'interconnexions V et aux premiers composants actifs C1. Les secondes surfaces de rayonnement A11 des premières antennes planaires A1 sont électriquement connectées aux premiers composants actifs C1.

## Couche métallique

La couche métallique 4 est préférentiellement réalisée en cuivre.

A titre d'exemple non limitatif, la couche métallique 4 peut présenter une épaisseur de l'ordre de 17 μm lorsque la fréquence de fonctionnement de l'antenne 2 à réseau transmetteur est de 29 GHz.

La couche métallique 4 peut être formée à la première surface 30 du substrat 3 par un procédé de métallisation tel qu'une croissance par électrolyse à travers un masque de résine à partir d'une sous-couche dite couche de nucléation (« *seed layer*» en langue anglaise).

## Couche d'un polymère durci

Le polymère durci est avantageusement un polymère thermodurcissable, de préférence un polyépoxyde. Le polyépoxyde peut être chargé en billes de silice.

La couche d'un polymère 5 durci présente avantageusement une épaisseur comprise entre 300 μm et 800 μm.

La couche d'un polymère 5 durci est formé par moulage (laminage, compression ou injection) sur la couche métallique 4.

## Deuxième structure d'interconnexions

L'empilement 1 comporte avantageusement une deuxième structure 7 d'interconnexions, intercalée entre la couche d'un polymère 5 durci et l'ensemble de deuxièmes antennes planaires A2. La deuxième structure 7 d'interconnexions est avantageusement formée sur la couche d'un polymère 5 durci dans une ligne de fabrication de niveaux d'interconnexions électriques BEOL (« *Back-End-Of-Line*» en langue anglaise).

La couche d'un polymère 5 durci présente alors avantageusement une surface 50, orientée vers la deuxième structure 7 d'interconnexions, et munie d'un ensemble de deuxièmes composants actifs C2 configurés pour introduire un déphasage.

La deuxième structure 7 d'interconnexions est électriquement connectée aux deuxièmes composants actifs C2, et comprend des deuxièmes lignes de polarisation 70 agencées pour polariser les deuxièmes composants actifs C2. Les deuxièmes lignes de polarisation 70 sont des pistes métalliques, de préférence réalisées en cuivre.

## Ensemble de deuxièmes composants actifs

Les deuxièmes composants actifs C2 sont avantageusement intégrés de manière monolithique à la couche d'un polymère 5 durci dans une ligne de fabrication de dispositifs semi-conducteurs FEOL (« *Front-End-Of-Line*» en langue anglaise), en utilisant des techniques de dépôt de couches minces à l'échelle de la plaque (« *wafer level*» en langue anglaise).

Chaque deuxième antenne planaire A2 comporte avantageusement des première et seconde surfaces de rayonnement A20, A21 disjointes, au sens où elles sont séparées entre elles par une zone de séparation de manière à être électriquement isolées entre elles. L'ensemble de deuxièmes composants actifs C2 comporte avantageusement des couples de commutateurs, chaque couple de commutateurs étant associé à une deuxième antenne planaire A2. Chaque couple de commutateurs appartient à un circuit de déphasage, et comprend des premier et second commutateurs présentant respectivement un état passant et un état bloqué en alternance, les états passant ou bloqué correspondant à une circulation d'un courant, respectivement autorisée ou bloquée, entre les première et seconde surfaces de rayonnement A20, A21 disjointes de chaque deuxième antenne planaire A2. Par « en alternance », on entend que le premier commutateur alterne entre l'état passant et l'état bloqué, tandis que, simultanément, le second commutateur alterne entre l'état bloqué et l'état passant. En d'autres termes, à tout instant, les premier et second commutateurs appartenant au même circuit de déphasage présentent deux états opposés, soit passant/bloqué, soit bloqué/passant. Les états passant/passant ou bloqué/bloqué ne sont pas autorisés.

Les deuxièmes composants actifs C2 sont de préférence choisis parmi une diode, un transistor à effet de champ, un transistor bipolaire, un microsystème électromécanique. Le transistor à effet de champ est de préférence un transistor de type MOS (« *Metal Oxide Semiconductor*» en langue anglaise). La diode peut être une diode de type p-i-n, une diode électro-optique, ou encore une diode de type varicap (« *varactor*» en langue anglaise). Les diodes de type p-i-n peuvent être réalisées en AlGaAs.

## Ensemble de deuxièmes antennes planaires

En présence de la deuxième structure 7 d'interconnexions, l'ensemble de deuxièmes antennes planaires A2 est formé sur la deuxième structure 7 d'interconnexions de manière à être électriquement connecté aux deuxièmes composants actifs C2. L'ensemble de deuxièmes antennes planaires A2 est formé sur la deuxième structure 7 d'interconnexions de sorte que les deuxièmes antennes planaires A2 sont électriquement isolées entre elles, afin de ne pas être mises en court-circuit.

Chaque deuxième antenne planaire A2 comporte avantageusement des première et seconde surfaces de rayonnement A20, A21 disjointes, au sens où elles sont séparées entre elles par une zone de séparation de manière à être électriquement isolées entre elles. A cet effet, une fente est avantageusement formée dans chaque deuxième antenne planaire A2 pour isoler électriquement les première et seconde surfaces de rayonnement A20, A21 disjointes. La fente définit la zone de séparation. La fente est préférentiellement annulaire, à section rectangulaire. Bien entendu, d'autres formes sont envisageables pour la fente, telles qu'une forme elliptique ou circulaire. Selon une variante d'exécution, l'isolation électrique des première et seconde surfaces de rayonnement A20, A21 de la deuxième antenne planaire A2 peut être assurée par un matériau diélectrique.

Les premières surfaces de rayonnement A20 des deuxièmes antennes planaires A2 sont électriquement connectées aux trous d'interconnexions V et aux deuxièmes composants actifs C2. Les secondes surfaces de rayonnement A21 des deuxièmes antennes planaires A2 sont électriquement connectées aux deuxièmes composants actifs C2.

Les ensembles des premières et deuxièmes antennes planaires A1, A2 sont alignés suivant la normale aux première et seconde surfaces 30, 31 du substrat 3. L'alignement des ensembles des premières et deuxièmes antennes planaires A1, A2 peut être obtenu par une technique d'alignement connue de l'homme du métier, par exemple à l'aide de caméras CCD (« *Charge Coupled Device* » en langue anglaise).

### Démultiplexeurs

L'empilement 1 comporte avantageusement des démultiplexeurs DMUX encapsulés dans la couche d'un polymère 5 durci, désaxés par rapport aux couples d'antennes planaires électriquement connectés, les démultiplexeurs DMUX étant électriquement connectés aux premières lignes de polarisation 60 pour transmettre un signal de commande. Les démultiplexeurs DMUX sont avantageusement électriquement connectés aux deuxièmes lignes de polarisation 70. Les connexions électriques entre les démultiplexeurs DMUX et les premières et deuxièmes lignes de polarisation 60, 70 ne sont pas représentées sur les figures pour des raisons de simplicité et de lisibilité.

Les démultiplexeurs DMUX sont avantageusement encapsulés dans la couche d'un polymère 5 durci par une technique de mise en boîtier à l'échelle du substrat avec épanouissement externe au circuit (« *Fan-out wafer-level packaging*» en langue anglaise), connue de l'homme du métier.

### Trous d'interconnexions / connexions électriques entre les antennes planaires

Les trous d'interconnexions V traversent des ouvertures formées dans la couche métallique 4. Les ouvertures formées dans la couche métallique 4 permettent à la fois l'isolation électrique avec les trous d'interconnexions V et la propagation des ondes électromagnétiques à travers la couche métallique 4 formant le plan de masse. Lorsque le substrat 3 est réalisé en silicium, les trous d'interconnexions V traversant le substrat 3 sont de type TSV (« *Through Silicon Via*» en langue anglaise). Les trous d'interconnexions V traversant la couche d'un polymère 5 durci sont de type TMV (« *Through Mold Via* » en langue anglaise), le polymère 5 durci étant moulé, et peuvent être formés sur la couche métallique 4 par une technique d'électrodéposition connue de l'homme du métier. A titre d'exemple, pour une fréquence de fonctionnement de 29 GHz, les trous d'interconnexions V présentent un diamètre de l'ordre de 150 $\mu$m. Les trous d'interconnexions V sont préférentiellement connectés aux premières et deuxièmes antennes planaires A1, A2 par des points de connexion. De manière générale, la position des points de connexion varie selon la géométrie spécifique des antennes planaires de manière à exciter le mode fondamental de résonance. Les trous d'interconnexion V s'étendent avantageusement suivant la normale aux surfaces des premières et deuxièmes antennes planaires A1, A2.

### Circuit intégré

Un objet de l'invention est un circuit intégré IC, fabriqué par une découpe d'un empilement 1 selon l'invention suivant la normale aux première et seconde surfaces 30, 31 du substrat 3, de manière à obtenir une pluralité de cellules élémentaires CE destinée à assurer une fonction de lentille électromagnétique pour une antenne 2 reconfigurable à réseau transmetteur, chaque cellule élémentaire CE comportant des première et deuxième antennes planaires A1, A2 alignées suivant la normale aux première et seconde surfaces 30, 31 du substrat 3.

La découpe peut être exécutée à l'aide d'une scie circulaire de précision, avec une lame à âme métallique ou à âme résinoïde diamantée.

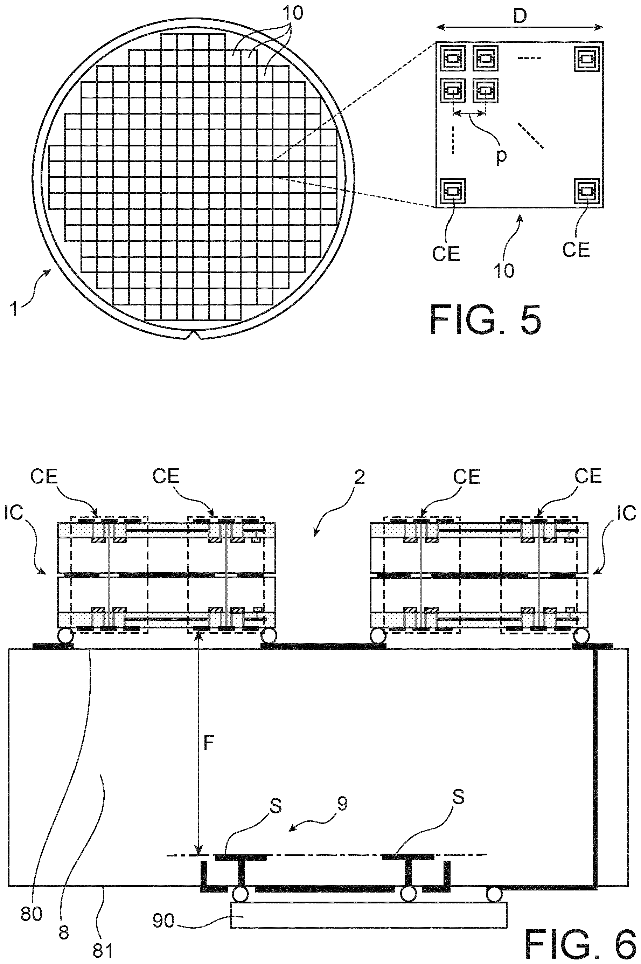

Avant la découpe, la surface de l'empilement 1 est divisée en motifs 10, comme illustré à la figure 5. Les motifs 10 sont formés à la surface de l'empilement 1, par exemple par photolithographie à l'aide d'un masque (réticule). A titre d'exemple non limitatif, chaque motif 10 peut être de forme carrée (D étant la dimension des côtés) et peut présenter une aire de 20x20 mm$^2$ lorsque le substrat 3 présente un diamètre de 200 mm. Le nombre de cellules élémentaires CE présentes dans un motif 10 dépend de la fréquence de fonctionnement de l'antenne 2, qui définit le pas p (« *pitch*» en langue anglaise) des cellules élémentaires CE. A titre d'exemple non limitatif, pour une fréquence de fonctionnement de 28 GHz, un motif 10 carré avec une aire de 20x20 mm$^2$ peut comporter 3x3 cellules élémentaires CE.

Autrement dit, un objet de l'invention est un circuit intégré IC destiné à assurer une fonction de lentille électromagnétique pour une antenne 2 reconfigurable à réseau transmetteur, fabriqué à partir d'un empilement 1 selon l'invention, le circuit intégré IC comportant successivement :

- une partie du substrat 3, comprenant des premiers composants actifs C1 configurés pour introduire un déphasage, et présentant des première et seconde surfaces 30, 31 opposées ; les premiers composants actifs C1 étant intégrés de manière monolithique à la partie du substrat 3 ;

- une partie de la couche métallique 4, formant un plan de masse à la première surface 30 de la partie du substrat 3 ;
- une partie de la couche d'un polymère 5 durci, formée sur la partie de la couche métallique 4 ;

le circuit intégré IC comportant :

- une partie de la première structure 6 d'interconnexions, formée à la seconde surface 31 de la partie du substrat 3, et électriquement connectée aux premiers composants actifs C1 ; la partie de la première structure 6 d'interconnexions comprenant des premières lignes de polarisation 60 agencées pour polariser les premiers composants actifs C1 ;
- des premières antennes planaires A1, formées sur la partie de la première structure 6 d'interconnexions de manière à être électriquement connecté aux premiers composants actifs C1 ;
- des deuxièmes antennes planaires A2, formées sur la partie de la couche d'un polymère 5 durci ; les premières et deuxièmes antennes planaires A1, A2 étant alignées suivant la normale aux première et seconde surfaces 30, 31 de la partie du substrat 3 ;
- une partie des trous d'interconnexions V, électriquement isolés de la partie de la couche métallique 4, et agencés pour connecter électriquement des couples d'antennes planaires ; chaque couple d'antennes planaires électriquement connecté comprenant des première et deuxième antennes planaires A1, A2 alignées suivant la normale aux première et seconde surfaces 30, 31 de la partie du substrat 3.

Selon un mode de réalisation, les démultiplexeurs DMUX sont encapsulés dans la partie de la couche d'un polymère 5 durci, désaxés par rapport aux couples d'antennes planaires électriquement connectés, les démultiplexeurs DMUX étant électriquement connectés aux premières lignes de polarisation 60 pour transmettre un signal de commande.

Selon un mode de réalisation, le circuit intégré IC comporte une partie de la deuxième structure 7 d'interconnexions, intercalée entre la partie de la couche d'un polymère 5 durci et les deuxièmes antennes planaires A2 ; circuit intégré IC dans lequel :

- la partie de la couche d'un polymère 5 durci présente une surface 50, orientée vers la partie de la deuxième structure 7 d'interconnexions, et munie de deuxièmes composants actifs C2 configurés pour introduire un déphasage ;
- la partie de la deuxième structure 7 d'interconnexions est électriquement connectée aux deuxièmes composants actifs C2, et comprend des deuxièmes lignes de polarisation 70 agencées pour polariser les deuxièmes composants actifs C2 ;
- les deuxièmes antennes planaires A2 sont formées sur la partie de la deuxième structure 7 d'interconnexions de manière à être électriquement connectées aux deuxièmes composants actifs C2.

### Antenne reconfigurable

Comme illustré à la figure 6, un objet de l'invention est une antenne 2 reconfigurable à réseau transmetteur, comportant :

- une carte 8 de circuit imprimé, présentant des première et seconde surfaces 80, 81 opposées ;
- au moins un circuit intégré IC selon l'invention, formé à la première surface 80 de la carte 8 de circuit imprimé ;
- au moins un émetteur-récepteur 9, agencé pour émettre et recevoir une onde électromagnétique se propageant au sein de la carte 8 de circuit imprimé ;
- au moins une électronique de commande 90, configurée pour commander l'émetteur-récepteur 9 et les premiers composants actifs C1 du circuit intégré IC, et formée à la seconde surface 81 de la carte 8 de circuit imprimé.

### Carte de circuit imprimé

La carte 8 de circuit imprimé est réalisée dans un matériau diélectrique. A titre d'exemple non limitatif, la carte 8 de circuit imprimé peut être réalisée dans un matériau commercial tel que le RT/duroid® 6002. La carte 8 de circuit imprimé présente une épaisseur typiquement comprise entre 100 $\mu$m et 1500 $\mu$m pour une fréquence de fonctionnement de l'antenne 2 comprise entre 10 GHz et 300 GHz. A titre d'exemple non limitatif, la carte 8 de circuit imprimé peut présenter une épaisseur de l'ordre de 254 $\mu$m lorsque la fréquence de fonctionnement de l'antenne 2 est de 29 GHz.

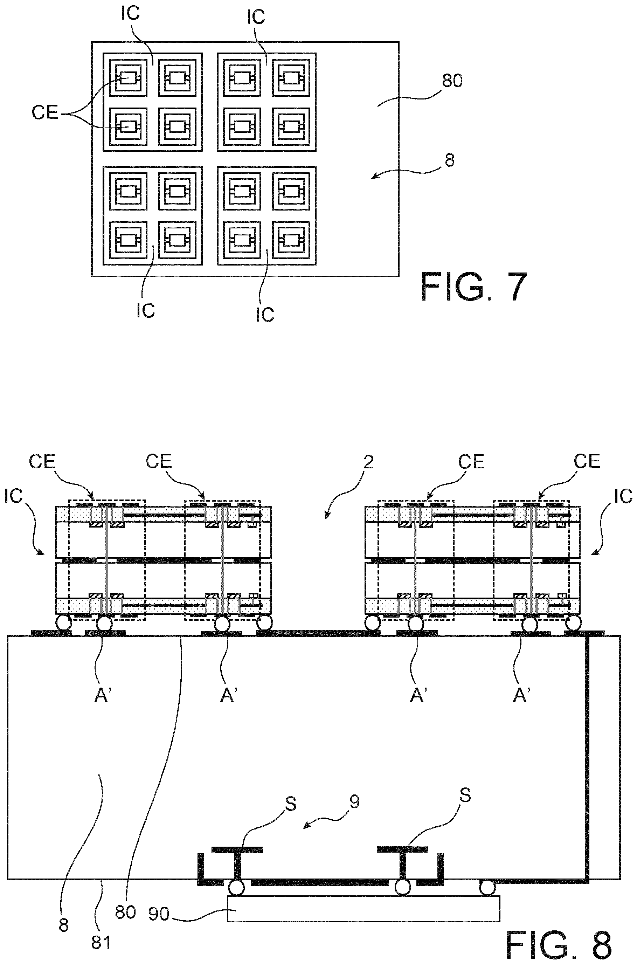

Le ou les circuits intégrés IC peuvent être formés sur la première surface 80 de la carte 8 de circuit imprimé par un assemblage de type puce retournée (« *flip-chip* » en langue anglaise). Les circuits intégrés IC peuvent être agencés sur la première surface 80 de la carte 8 de circuit imprimé sous forme matricielle, comme illustré à la figure 7.

Comme illustré à la figure 8, l'antenne 2 comporte avantageusement des antennes planaires additionnelles A', formées à la première surface 80 de la carte 8 de circuit imprimé, et alignées avec les cellules élémentaires CE du circuit intégré IC suivant la normale aux première et seconde surfaces 30, 31 du substrat 3.

### Emetteur-Récepteur

Chaque émetteur-récepteur 9 comporte au moins une source S rayonnante agencée pour émettre des ondes électromagnétiques. La source S rayonnante peut être réalisée sous la forme d'une antenne planaire formée au sein de la carte 8 de circuit imprimé, s'étendant dans un plan focal dont la distance euclidienne avec la lentille électromagnétique définit la distance focale F (illustrée à la figure 6). La ou chaque source S rayonnante est avantageusement configurée pour opérer à une fréquence supérieure à 30 GHz (fréquences millimétriques et sub-THz).

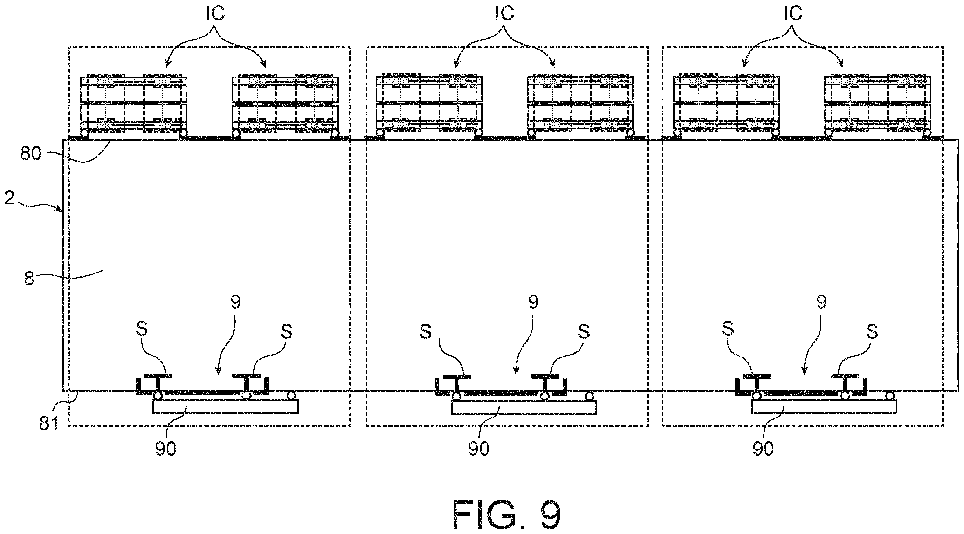

Comme illustré à la figure 9, l'antenne 2 peut comporter une pluralité d'émetteurs-récepteurs 9. Lorsque les circuits intégrés IC sont agencés sur la première surface 80 de la carte 8 de circuit imprimé sous forme matricielle, chaque émetteur-récepteur 9 peut être dédié à une zone de la matrice.

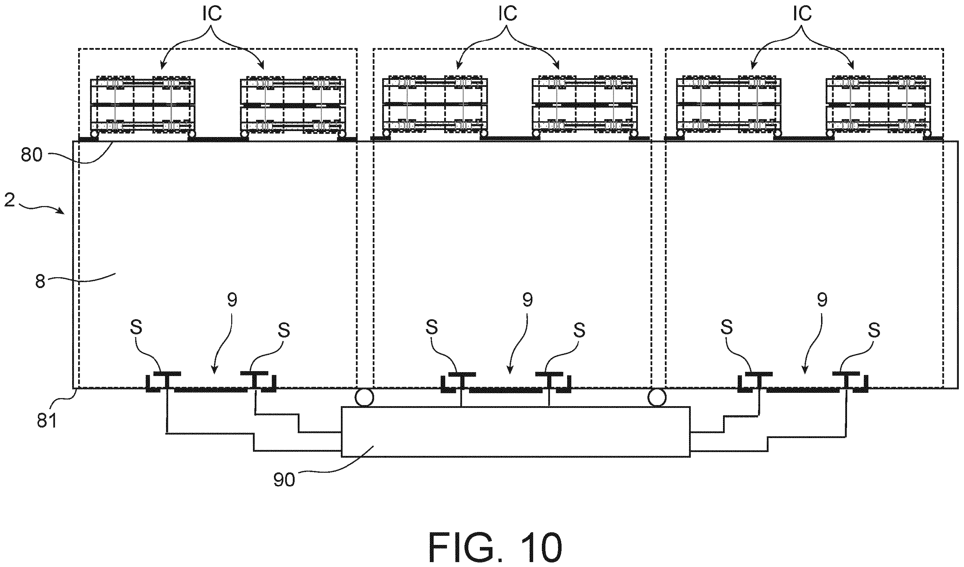

Comme illustré à figure 10, la pluralité d'émetteurs-récepteurs 9 peut être commandée par une électronique de commande 90 numérique, dont les voies de sortie sont électriquement connectées aux sources S rayonnantes.

**Electronique de commande**

L'électronique de commande 90 est préférentiellement intégrée au sein d'une puce électronique montée sur la seconde surface 81 de la carte 8 de circuit imprimé. L'électronique de commande 90 est avantageusement configurée pour commander les deuxièmes composants actifs C2 du circuit intégré IC.

En l'absence de démultiplexeurs DMUX encapsulés dans la couche d'un polymère 5 durci, des démultiplexeurs peuvent être déportés au sein de l'électronique de commande 90. Un exemple de pilotage des lignes de polarisation est donné dans la thèse de doctorat « Conception d'antennes à réseaux transmetteurs à dépointage et/ ou formation de faisceau », A. Clemente, octobre 2012, aux pages 159-161.

L'invention ne se limite pas aux modes de réalisation exposés. L'homme du métier est mis à même de considérer leurs combinaisons techniquement opérantes.

**Revendications**

1. Empilement (1) pour fabriquer un circuit intégré (IC) destiné à assurer une fonction de lentille électromagnétique pour une antenne (2) reconfigurable à réseau transmetteur, l'empilement (1) comportant successivement :

    - un substrat (3), comprenant un ensemble de premiers composants actifs (C1) configurés pour introduire un déphasage, et présentant des première et seconde surfaces (30, 31) opposées ; les premiers composants actifs (C1) étant intégrés de manière monolithique au substrat (3) ;
    - une couche métallique (4), formant un plan de masse à la première surface (30) du substrat (3) ;
    - une couche d'un polymère (5) durci, formée sur la couche métallique (4) ;

l'empilement (1) comportant :

    - une première structure (6) d'interconnexions, formée à la seconde surface (31) du substrat (3), et électriquement connectée aux premiers composants actifs (C1) ; la première structure (6) d'interconnexions comprenant des premières lignes de polarisation (60) agencées pour polariser les premiers composants actifs (C1) ;
    - un ensemble de premières antennes planaires (A1), formé sur la première structure (6) d'interconnexions de manière à être électriquement connecté aux premiers composants actifs (C1) ;
    - un ensemble de deuxièmes antennes planaires (A2), formé sur la couche d'un polymère (5) durci ; les ensembles des premières et deuxièmes antennes planaires (A1, A2) étant alignés suivant la normale aux première et seconde surfaces (30, 31) du substrat (3) ;
    - des trous d'interconnexions (V), électriquement isolés de la couche métallique (4), et agencés pour connecter électriquement des couples d'antennes planaires ; chaque couple d'antennes planaires électriquement connecté comprenant des première et deuxième antennes planaires (A1, A2) alignées suivant la normale aux première et seconde surfaces (30, 31) du substrat (3).

2. Empilement (1) selon la revendication 1, comportant des démultiplexeurs (DMUX) encapsulés dans la couche d'un polymère (5) durci, désaxés par rapport aux couples d'antennes planaires électriquement connectés, les démultiplexeurs (DMUX) étant électriquement connectés aux premières lignes de polarisation (60) pour transmettre un signal de commande.

3. Empilement (1) selon la revendication 1 ou 2, dans lequel l'ensemble de premiers composants actifs (C1) comporte des couples de commutateurs, chaque couple de commutateurs étant associé à une première antenne planaire (A1) ; les premiers composants actifs (C1) étant de préférence choisis parmi une diode, un transistor à effet de champ, un transistor bipolaire, un microsystème électromécanique.

4. Empilement (1) selon l'une des revendications 1 à 3, comportant une deuxième structure (7) d'interconnexions, intercalée entre la couche d'un polymère (5) durci et l'ensemble de deuxièmes antennes planaires (A2) ; empilement (1) dans lequel :

    - la couche d'un polymère (5) durci présente une surface (50), orientée vers la deuxième structure (7) d'interconnexions, et munie d'un ensemble de deuxièmes composants actifs (C2) configurés pour introduire un déphasage ;
- la deuxième structure (7) d'interconnexions est électriquement connectée aux deuxièmes composants actifs (C2), et comprend des deuxièmes lignes de polarisation (70) agencées pour polariser les deuxièmes composants actifs (C2) ;
- l'ensemble de deuxièmes antennes planaires (A2) est formé sur la deuxième structure (7) d'interconnexions de manière à être électriquement connecté aux deuxièmes composants actifs (C2).

5. Empilement (1) selon la revendication 4, dans lequel l'ensemble de deuxièmes composants actifs (C2) comporte des couples de commutateurs, chaque couple de commutateurs étant associé à une deuxième antenne planaire (A2) ; les deuxièmes composants actifs (C2) étant de préférence choisis parmi une diode, un transistor à effet de champ, un transistor bipolaire, un microsystème électromécanique.

6. Empilement (1) selon la revendication 4 ou 5 en combinaison avec la revendication 2, dans lequel les démultiplexeurs (DMUX) sont électriquement connectés aux deuxièmes lignes de polarisation (70).

7. Empilement (1) selon l'une des revendications 4 à 6, dans lequel :

    - chaque deuxième antenne planaire (A2) comporte des première et seconde surfaces de rayonnement (A20, A21) disjointes ;
    - les premières surfaces de rayonnement (A20) des deuxièmes antennes planaires (A2) sont électriquement connectées aux trous d'interconnexions (V) et aux deuxièmes composants actifs (C2) ;
    - les secondes surfaces de rayonnement (A21) des deuxièmes antennes planaires (A2) sont électriquement connectées aux deuxièmes composants actifs (C2).

8. Empilement (1) selon l'une des revendications 1 à 7, dans lequel :

    - chaque première antenne planaire (A1) comporte des première et seconde surfaces de rayonnement (A10, A11) disjointes ;
    - les premières surfaces de rayonnement (A10) des premières antennes planaires (A1) sont électriquement connectées aux trous d'interconnexions (V) et aux premiers composants actifs (C1) ;
    - les secondes surfaces de rayonnement (A11) des premières antennes planaires (A1) sont électriquement connectées aux premiers composants actifs (C1).

9. Empilement (1) selon l'une des revendications 1 à 8, dans lequel le substrat (3) est choisi parmi :

    - un substrat (3) réalisé à base d'un matériau semi-conducteur ou constitué d'un matériau semi-conducteur ;
    - un substrat (3) réalisé dans un matériau diélectrique.

10. Empilement (1) selon l'une des revendications 1 à 9, dans lequel le polymère durci est un polymère thermodurcissable, de préférence un polyépoxyde.

11. Empilement (1) selon l'une des revendications 1 à 10, dans lequel la couche d'un polymère (5) durci présente une épaisseur comprise entre 300 $\mu$m et 800 $\mu$m.

12. Circuit intégré (IC) fabriqué à partir d'un empilement (1) selon l'une des revendications 1 à 11 de manière à obtenir une pluralité de cellules élémentaires (CE) destinée à assurer une fonction de lentille électromagnétique pour une antenne (2) reconfigurable à réseau transmetteur, chaque cellule élémentaire (CE) comportant des première et deuxième antennes planaires (A1, A2) alignées suivant la normale aux première et seconde surfaces (30, 31) du substrat (3), le circuit intégré (IC) comportant successivement :

    - une partie du substrat (3), comprenant des premiers composants actifs (C1) configurés pour introduire un déphasage, et présentant des première et seconde surfaces (30, 31) opposées ; les premiers composants actifs (C1) étant intégrés de manière monolithique à la partie du substrat (3) ;
    - une partie de la couche métallique (4), formant un plan de masse à la première surface (30) de la partie du substrat (3) ;
    - une partie de la couche d'un polymère (5) durci, formée sur la partie de la couche métallique (4) ;

    le circuit intégré (IC) comportant :

    - une partie de la première structure (6) d'interconnexions, formée à la seconde surface (31) de la partie du substrat (3), et électriquement connectée aux premiers composants actifs (C1) ; la partie de la première structure (6) d'interconnexions comprenant des premières lignes de polarisation (60) agencées pour polariser les premiers composants actifs (C1) ;
    - des premières antennes planaires (A1) de l'ensemble de premières antennes planaires (A1), formées sur la partie de la première structure (6) d'interconnexions de manière à être électriquement connecté aux premiers composants actifs (C1) ;
- des deuxièmes antennes planaires (A2) de l'ensemble de deuxièmes antennes planaires (A2), formées sur la partie de la couche d'un polymère (5) durci ; les premières et deuxièmes antennes planaires (A1, A2) étant alignées suivant la normale aux première et seconde surfaces (30, 31) de la partie du substrat (3) ;
- une partie des trous d'interconnexions (V), électriquement isolés de la partie de la couche métallique (4), et agencés pour connecter électriquement des couples d'antennes planaires ; chaque couple d'antennes planaires électriquement connecté comprenant des première et deuxième antennes planaires (A1, A2) alignées suivant la normale aux première et seconde surfaces (30, 31) de la partie du substrat (3).

13. Antenne (2) reconfigurable à réseau transmetteur, comportant :

- une carte (8) de circuit imprimé, présentant des première et seconde surfaces (80, 81) opposées ;
- au moins un circuit intégré (IC) selon la revendication 12, formé à la première surface (80) de la carte (8) de circuit imprimé ;
- au moins un émetteur-récepteur (9), agencé pour émettre et recevoir une onde électromagnétique se propageant au sein de la carte (8) de circuit imprimé ;
- au moins une électronique de commande (90), configurée pour commander l'émetteur-récepteur (9) et les premiers composants actifs (C1) du circuit intégré (IC), et formée à la seconde surface (81) de la carte (8) de circuit imprimé.

14. Antenne (2) selon la revendication 13, comportant au moins un circuit intégré (IC) selon la revendication 12 en combinaison avec la revendication 4 ; antenne (2) dans laquelle l'électronique de commande (90) est configurée pour commander les deuxièmes composants actifs (C2) du circuit intégré (IC).

15. Antenne (2) selon la revendication 13 ou 14, comportant des antennes planaires additionnelles (A'), formées à la première surface (80) de la carte (8) de circuit imprimé, et alignées avec les cellules élémentaires (CE) du circuit intégré (IC) suivant la normale aux première et seconde surfaces (30, 31) du substrat (3).

**Patentansprüche**

1. Stapel (1) zum Herstellen einer integrierten Schaltung (IC), die dazu bestimmt ist, eine Funktion einer elektromagnetischen Linse für eine rekonfigurierbare Transmitarray-Antenne (2) zu gewährleisten, wobei der Stapel (1) nacheinander beinhaltet:

- ein Substrat (3), das eine Anordnung von ersten aktiven Bauelementen (C1) umfasst, die dazu ausgestaltet sind, eine Phasenverschiebung einzuführen, und entgegengesetzte erste und zweite Flächen (30, 31) aufweist; wobei die ersten aktiven Bauelemente (C1) monolithisch in das Substrat (3) integriert sind;
- eine Metallschicht (4), die eine Masseebene an der ersten Fläche (30) des Substrat (3) bildet;
- eine Schicht aus einem gehärteten Polymer (5), die auf der Metallschicht (4) gebildet ist;

wobei der Stapel (1) beinhaltet:

- eine erste Kontaktierungsstruktur (6), die an der zweiten Fläche (31) des Substrats (3) gebildet ist und mit den ersten aktiven Bauelementen (C1) elektrisch verbunden ist; wobei die erste Kontaktierungsstruktur (6) erste Polarisationsleitungen (60) umfasst, die dazu eingerichtet sind, die ersten aktiven Bauelemente (C1) zu polarisieren;
- eine Anordnung von ersten Planarantennen (A1), die auf der ersten Kontaktierungsstruktur (6) gebildet ist, so dass sie mit den ersten aktiven Bauelementen (C1) elektrisch verbunden ist;
- eine Anordnung von zweiten Planarantennen (A2), die auf der Schicht aus einem gehärteten Polymer (5) gebildet ist; wobei die Anordnungen der ersten und zweiten Planarantennen (A1, A2) entlang der Normalen zu den ersten und zweiten Flächen (30, 31) des Substrats (3) ausgerichtet sind;
- Kontaktierungslöcher (V), die von der Metallschicht (4) elektrisch isoliert sind und dazu eingerichtet sind, Planarantennenpaare elektrisch zu verbinden; wobei jedes elektrisch verbundene Planarantennenpaar erste und zweite Planarantennen (A1, A2) umfasst, die entlang der Normalen zu den ersten und zweiten Flächen (30, 31) des Substrats (3) ausgerichtet sind.

2. Stapel (1) nach Anspruch 1, der in die Schicht aus einem gehärteten Polymer (5) gekapselte Demultiplexer (DMUX) beinhaltet, die in Bezug auf die elektrisch verbundenen Planarantennenpaare versetzt sind, wobei die Demultiplexer (DMUX) mit den ersten Polarisationsleitungen (60) elektrisch verbunden sind, um ein Steuersignal zu übertragen.

3. Stapel (1) nach Anspruch 1 oder 2, bei dem die Anordnung von ersten aktiven Bauelementen (C1) Schalterpaare beinhaltet, wobei jedes Schalterpaar einer ersten Planarantenne (A1) zugeordnet ist; wobei die ersten aktiven Bauelemente (C1) bevorzugt unter einer Diode, einem Feldeffekttransistor, einem Bipolartransistor, einem mikro-elektromechanischen System gewählt sind.

4. Stapel (1) nach einem der Ansprüche 1 bis 3, der eine zweite Kontaktierungsstruktur (7) beinhaltet, die zwischen der Schicht aus einem gehärteten Polymer (5) und der Anordnung von zweiten Planarantennen (A2) angeordnet ist; Stapel (1), bei dem:

   - die Schicht aus einem gehärteten Polymer (5) eine Fläche (50) aufweist, die zu der zweiten Kontaktierungsstruktur (7) hin ausgerichtet ist und mit einer Anordnung von zweiten aktiven Bauelementen (C2) versehen ist, die dazu ausgestaltet sind, eine Phasenverschiebung einzuführen;
   - die zweite Kontaktierungsstruktur (7) mit den zweiten aktiven Bauelementen (C2) elektrisch verbunden ist und zweite Polarisationsleitungen (70) umfasst, die dazu eingerichtet sind, die zweiten aktiven Bauelemente (C2) zu polarisieren;
   - die Anordnung von zweiten Planarantennen (A2) auf der zweiten Kontaktierungsstruktur (7) gebildet ist, so dass sie mit den zweiten aktiven Bauelementen (C2) elektrisch verbunden ist.

5. Stapel (1) nach Anspruch 4, bei dem die Anordnung von zweiten aktiven Bauelementen (C2) Schalterpaare beinhaltet, wobei jedes Schalterpaar einer zweiten Planarantenne (A2) zugeordnet ist; wobei die zweiten aktiven Bauelemente (C2) bevorzugt unter einer Diode, einem Feldeffekttransistor, einem Bipolartransistor, einem mikro-elektromechanischen System gewählt sind.

6. Stapel (1) nach Anspruch 4 oder 5 in Kombination mit Anspruch 2, bei dem die Demultiplexer (DMUX) mit den zweiten Polarisationsleitungen (70) elektrisch verbunden sind.

7. Stapel (1) nach einem der Ansprüche 4 bis 6, bei dem:

   - jede zweite Planarantenne (A2) erste und zweite getrennte Strahlungsflächen (A20, A21) beinhaltet;
   - die ersten Strahlungsflächen (A20) der zweiten Planarantennen (A2) mit den Kontaktierungslöchern (V) und mit den zweiten aktiven Bauelementen (C2) elektrisch verbunden sind;
   - die zweiten Strahlungsflächen (A21) der zweiten Planarantennen (A2) mit den zweiten aktiven Bauelementen (C2) elektrisch verbunden sind.

8. Stapel (1) nach einem der Ansprüche 1 bis 7, bei dem:

   - jede erste Planarantenne (A1) erste und zweite getrennte Strahlungsflächen (A10, A11) beinhaltet;
   - die ersten Strahlungsflächen (A10) der ersten Planarantennen (A1) mit den Kontaktierungslöchern (V) und mit den ersten aktiven Bauelementen (C1) elektrisch verbunden sind;
   - die zweiten Strahlungsflächen (A11) der ersten Planarantennen (A1) mit den ersten aktiven Bauelementen (C1) elektrisch verbunden sind.

9. Stapel (1) nach einem der Ansprüche 1 bis 8, bei dem das Substrat (3) ausgewählt ist unter:

   - einem Substrat (3), das auf Basis eines Halbleitermaterials ausgeführt ist oder aus einem Halbleitermaterial besteht;
   - einem Substrat (3), das aus einem dielektrischen Material ausgeführt ist.

10. Stapel (1) nach einem der Ansprüche 1 bis 9, bei dem das gehärtete Polymer ein duroplastisches Polymer ist, bevorzugt ein Polyepoxid.

11. Stapel (1) nach einem der Ansprüche 1 bis 10, bei dem die Schicht aus einem gehärteten Polymer (5) eine Dicke zwischen 300 $\mu$m und 800 $\mu$m aufweist.

12. Integrierte Schaltung (IC), die ausgehend von einem Stapel (1) nach einem der Ansprüche 1 bis 11 hergestellt ist, so dass eine Mehrzahl von elementaren Zellen (CE) erhalten wird, die dazu bestimmt ist, eine Funktion einer elektromagnetischen Linse für eine rekonfigurierbare Transmitarray-Antenne (2) zu gewährleisten, wobei jede elementare Zelle (CE) erste und zweite Planarantennen (A1, A2) beinhaltet, die entlang der Normalen zu den ersten und zweiten Flächen (30, 31) des Substrats (3) ausgerichtet sind, wobei die integrierte Schaltung (IC) nacheinander beinhaltet:

   - einen Teil des Substrats (3), der erste aktive Bauelemente (C1) beinhaltet, die dazu ausgestaltet sind, eine Phasenverschiebung einzuführen, und entgegengesetzte erste und zweite Flächen (30, 31) aufweist; wobei die ersten aktiven Bauelemente (C1) monolithisch in den Teil des Substrats (3) integriert sind;
   - einen Teil der Metallschicht (4), der eine Masseebene an der ersten Fläche (30) des Teils des Substrats (3) bildet;
   - einen Teil der Schicht aus einem gehärteten Polymer (5), der auf dem Teil der Metallschicht (4) gebildet ist;

   wobei die integrierte Schaltung (IC) beinhaltet:

- einen Teil der ersten Kontaktierungsstruktur (6), der an der zweiten Fläche (31) des Teils des Substrats (3) gebildet ist und mit den ersten aktiven Bauelementen (C1) elektrisch verbunden ist; wobei der Teil der ersten Kontaktierungsstruktur (6) erste Polarisationsleitungen (60) umfasst, die dazu eingerichtet sind, die ersten aktiven Bauelemente (C1) zu polarisieren;
- erste Planarantennen (A1) der Anordnung von ersten Planarantennen (A1), die auf dem Teil der ersten Kontaktierungsstruktur (6) gebildet sind, so dass sie mit den ersten aktiven Bauelementen (C1) elektrisch verbunden sind;
- zweite Planarantennen (A2) der Anordnung von zweiten Planarantennen (A2), die auf dem Teil der Schicht aus einem gehärteten Polymer (5) gebildet sind; wobei die ersten und zweiten Planarantennen (A1, A2) entlang der Normalen zu den ersten und zweiten Flächen (30, 31) des Teils des Substrats (3) ausgerichtet sind;
- einen Teil der Kontaktierungslöcher (V), die von dem Teil der Metallschicht (4) elektrisch isoliert sind und dazu eingerichtet sind, Planarantennenpaare elektrisch zu verbinden; wobei jedes elektrisch verbundene Planarantennenpaar erste und zweite Planarantennen (A1, A2) umfasst, die entlang der Normalen zu den ersten und zweiten Flächen (30, 31) des Teils des Substrats (3) ausgerichtet sind.

13. Rekonfigurierbare Transmitarray-Antenne (2), die beinhaltet:

- eine Leiterplatte (8), die entgegengesetzte erste und zweite Flächen (80, 81) aufweist;
- mindestens eine integrierte Schaltung (IC) nach Anspruch 12, die an der ersten Fläche (80) der Leiterplatte (8) gebildet ist;
- mindestens einen Sender-Empfänger (9), der dazu eingerichtet ist, eine elektromagnetische Welle zu senden und zu empfangen, die sich in der Leiterplatte (8) ausbreitet;
- mindestens eine Steuerelektronik (90), die dazu ausgestaltet ist, den Sender-Empfänger (9) und die ersten aktiven Bauelemente (C1) der integrierten Schaltung (IC) zu steuern, und an der zweiten Fläche (81) der Leiterplatte (8) gebildet ist.

14. Antenne (2) nach Anspruch 13, die mindestens eine integrierte Schaltung (IC) nach Anspruch 12 in Kombination mit Anspruch 4 beinhaltet; Antenne (2), bei der die Steuerelektronik (90) dazu ausgestaltet ist, die zweiten aktiven Bauelemente (C2) der integrierten Schaltung (IC) zu steuern.

15. Antenne (2) nach Anspruch 13 oder 14, die zusätzliche Planarantennen (A') beinhaltet, die an der ersten Fläche (80) der Leiterplatte (8) gebildet sind und mit den elementaren Zellen (CE) der integrierten Schaltung (IC) entlang der Normalen zu den ersten und zweiten Flächen (30, 31) des Substrats (3) ausgerichtet sind.

## Claims

1. Stack (1) for fabricating an integrated circuit (IC) intended to perform an electromagnetic-lens function for a reconfigurable transmitarray antenna (2), the stack (1) comprising in succession:

   - a substrate (3) that comprises a set of first active components (C1) configured to generate a phase shift, and that has first and second opposite surfaces (30, 31), the first active components (C1) being integrated monolithically into the substrate (3);
   - a metal layer (4), forming a ground plane on the first surface (30) of the substrate (3);
   - a layer of a cured polymer (5), formed on the metal layer (4);

   the stack (1) comprising:

   - a first interconnect structure (6) formed on the second surface (31) of the substrate (3), and electrically connected to the first active components (C1), the first interconnect structure (6) comprising first biasing lines (60) arranged to bias the first active components (C1);
   - a set of first planar antennas (A1) that is formed on the first interconnect structure (6) so as to be electrically connected to the first active components (C1);
   - a set of second planar antennas (A2) that is formed on the layer of a cured polymer (5), the sets of first and second planar antennas (A1, A2) being aligned along the normal to the first and second surfaces (30, 31) of the substrate (3);
   - vias (V) that are electrically insulated from the metal layer (4) and that are arranged to electrically connect pairs of planar antennas, each electrically connected pair of planar antennas comprising first and second planar antennas (A1, A2) that are aligned along the normal to the first and second surfaces (30, 31) of the substrate (3).

2. Stack (1) according to Claim 1, comprising demultiplexers (DMUX) that are encapsulated in the layer of a cured polymer (5) and that are off-axis with respect to the electrically connected pairs of planar antennas, the demultiplexers (DMUX) being electrically connected to the first biasing lines (60) with a view to transmission of a control signal.

3. Stack (1) according to Claim 1 or 2, wherein the set of first active components (C1) comprises pairs of switches, each pair of switches being associated with one first planar antenna (A1), the first active components (C1) preferably being chosen from a diode, a field-effect transistor, a bipolar transistor, and a micro-electromechanical system.

4. Stack (1) according to one of Claims 1 to 3, comprising a second interconnect structure (7) intermediate between the layer of a cured polymer (5) and the set of second planar antennas (A2), in which stack (1):

   - the layer of a cured polymer (5) has a surface (50) that is oriented toward the second interconnect structure (7) and equipped with a set of second active components (C2) that are configured to generate a phase shift;
   - the second interconnect structure (7) is electrically connected to the second active components (C2) and comprises second biasing lines (70) that are arranged to bias the second active components (C2);
   - the set of second planar antennas (A2) is formed on the second interconnect structure (7) so as to be electrically connected to the second active components (C2).

5. Stack (1) according to Claim 4, wherein the set of second active components (C2) comprises pairs of switches, each pair of switches being associated with one second planar antenna (A2), the second active components (C2) preferably being chosen from a diode, a field-effect transistor, a bipolar transistor, and a micro-electromechanical system.

6. Stack (1) according to Claim 4 or 5 in combination with Claim 2, wherein the demultiplexers (DMUX) are electrically connected to the second biasing lines (70).

7. Stack (1) according to one of Claims 4 to 6, wherein:

   - each second planar antenna (A2) comprises separate first and second radiating areas (A20, A21);
   - the first radiating areas (A20) of the second planar antennas (A2) are electrically connected to the vias (V) and to the second active components (C2);
   - the second radiating areas (A21) of the second planar antennas (A2) are electrically connected to the second active components (C2).

8. Stack (1) according to one of Claims 1 to 7, wherein:

   - each first planar antenna (A1) comprises separate first and second radiating areas (A10, A11);
   - the first radiating areas (A10) of the first planar antennas (A1) are electrically connected to the vias (V) and to the first active components (C1);
   - the second radiating areas (A11) of the first planar antennas (A1) are electrically connected to the first active components (C1).

9. Stack (1) according to one of Claims 1 to 8, wherein the substrate (3) is chosen from:

   - a substrate (3) made based on a semiconductor or consisting of a semiconductor;
   - a substrate (3) made of a dielectric.

10. Stack (1) according to one of Claims 1 to 9, wherein the cured polymer is a thermoset polymer, and preferably a polyepoxide.

11. Stack (1) according to one of Claims 1 to 10, wherein the layer of a cured polymer (5) has a thickness comprised between 300 $\mu$m and 800 $\mu$m.

12. Integrated circuit (IC) fabricated from a stack (1) according to one of Claims 1 to 11 so as to obtain a plurality of elementary cells (CE) that is intended to perform an electromagnetic-lens function for a reconfigurable transmitarray antenna (2), each elementary cell (CE) comprising first and second planar antennas (A1, A2) that are aligned along the normal to the first and second surfaces (30, 31) of the substrate (3), the integrated circuit (IC) comprising in succession:

   - a portion of the substrate (3) that comprises first active components (C1) configured to generate a phase shift, and that has first and second opposite surfaces (30, 31), the first active components (C1) being integrated monolithically into the portion of the substrate (3);
   - a portion of the metal layer (4), forming a ground plane on the first surface (30) of the portion of the substrate (3);
   - a portion of the layer of a cured polymer (5), formed on the portion of the metal layer (4);

   the integrated circuit (IC) comprising:

   - a portion of the first interconnect structure (6), formed on the second surface (31) of the portion of the substrate (3), and electrically connected to the first active components (C1), the portion of the first interconnect structure (6) comprising first biasing lines (60) arranged to bias the first active components (C1);
   - first planar antennas (A1) of the set of first planar antennas (A1), formed on the portion of the first interconnect structure (6) so as to be electrically connected to the first active components (C1);

- second planar antennas (A2) of the set of second planar antennas (A2), formed on the portion of the layer of a cured polymer (5), the first and second planar antennas (A1, A2) being aligned along the normal to the first and second surfaces (30, 31) of the portion of the substrate (3);

- some of the vias (V) that are electrically insulated from the metal layer (4) and that are arranged to electrically connect pairs of planar antennas, each electrically connected pair of planar antennas comprising first and second planar antennas (A1, A2) that are aligned along the normal to the first and second surfaces (30, 31) of the portion of the substrate (3).

13. Reconfigurable transmitarray antenna (2), comprising:

- a printed circuit board (8) having first and second opposite surfaces (80, 81);
- at least one integrated circuit (IC) according to Claim 12, formed on the first surface (80) of the printed circuit board (8);
- at least one transceiver (9), arranged to transmit and receive an electromagnetic wave propagating within the printed circuit board (8);
- at least one electronic control device (90) that is configured to control the transceiver (9) and the first active components (C1) of the integrated circuit (IC) and that is formed on the second surface (81) of the printed circuit board (8).

14. Antenna (2) according to Claim 13, comprising at least one integrated circuit (IC) according to Claim 12 in combination with Claim 4, in which antenna (2) the electronic control device (90) is configured to control the second active components (C2) of the integrated circuit (IC).

15. Antenna (2) according to Claim 13 or 14, comprising additional planar antennas (A') that are formed on the first surface (80) of the printed circuit board (8) and that are aligned with the elementary cells (CE) of the integrated circuit (IC) along the normal to the first and second surfaces (30, 31) of the substrate (3).

FIG. 1

FIG. 2

FIG. 3

FIG. 4

FIG. 5

FIG. 6

FIG. 7

FIG. 8

FIG. 9

EP 4 099 498 B1

FIG. 10

**RÉFÉRENCES CITÉES DANS LA DESCRIPTION**

**Documents brevets cités dans la description**

- US 2018301807 A1

**Littérature non-brevet citée dans la description**

- **J. A. ZEVALLOS LUNA.** *Intégration d'antennes pour objets communicants aux fréquences millimétriques,* Octobre 2014

- **A. CLEMENTE.** *Conception d'antennes à réseaux transmetteurs à dépointage et/ ou formation de faisceau,* Octobre 2012, 159-161